# EUROPEAN PATENT SPECIFICATION

(11) **EP 0 311 989 B1**
(45) Date of publication and mention of the grant of the patent: **07.01.1993**
(21) Application number: 88116882.7
(22) Date of filing: 12.10.1988
(51) Int. Cl.: C08J 7/12, D06M 10/00, C08J 5/12

(54) **Surface treatment of polyethylene fibers**
Oberflächenbehandlung von Fasern aus Polyethylen
Traitement superficiel de fibres de polyethylene

(30) Priority: 14.10.1987 NL 8702448
(43) Date of publication of application: 19.04.1989
(73) Proprietor: DYNEEMA V.O.F., NL-6136 GM Sittard (NL)
(72) Inventor: Cree, Stephen Henry, Blairlogie Stirling (GB); Rutten, Hendrikus Johannes Jozef, NL-6211 BP Maastricht (NL)
(74) Representative: Hoogstraten, Willem Cornelis Roeland

(56) References cited:
- EP-A- 0 144 997
- GB-A- 1 123 048
- GB-A- 1 304 077
- US-A- 4 499 148
- US-A- 4 654 262
- US-A- 4 668 717
- CHEMICAL ABSTRACTS, vol. 79, no. 18, 1973, page 29, abstract no. 105955z, Columbus, Ohio, US

## Description

The invention relates to a process for the treatment of surfaces of polyethylene fibers.

Polyolefins are nonpolar polymers that have been known for a long time and which can be, and are, used for a large number of purposes. A number of applications consist in combining polyolefins with other substances (or plastics), for example in multi-layer films or composites, or applying an adhesive, ink or paint layer or a coating to an object manufactured from a polyolefin. Use is often made of materials with a polar character in these applications. A problem in such applications is the nonpolarity of the polyolefins, on account of which it is very difficult to obtain good adhesion between the non-polar polyolefin and materials that are more polar than the polyolefin, for example polar substances (or plastics), resins and metals.

Various solutions to this problem have been suggested, for example treating the polyolefin object with oxidizing liquids such as chromic acid (so-called etching) or subjecting it to a plasma discharge treatment as described in EP-A-62.491. However, these methods are complicated or expensive, or the strength and the stiffness of the polyolefin material are affected while, moreover, the adhesion is often unsatisfactory. In CHEMICAL ABSTRACTS, vol. 79, no. 18, abstract no. 105 955z a polypropylene film is oxidized and then contacted with a titanate complex in order to improve the printability for inks.

The aim of the invention is to find a process for treating surfaces of polyethylene fibers to obtain good adhesion to materials of a more polar nature than the polyolefin without the aforementioned disadvantages.

The invention relates to a process for the treatment of the surface of highly oriented polyethylene fibers which is characterized in that the surface of the fibers is oxidized and contacted with a solution of a silane compound, a titanate or chromium complex.

In particular the invention relates to a process for treating the surface of highly oriented polyethylene fibers. The fibers are obtained by converting a solution or melt of a linear polyethylene with a weight average molecular weight of at least 400,000 g/mol, at a temperature above the dissolution temperature or above the melting temperature, respectively, into a fiber, cooling this fiber to form a solid, gel-like fiber and stretching this fiber, at increased temperature, whether or not after complete or partial removal of the solvent.

The oxidation of the surface can be effected in different ways, for example by treatment with very powerful oxidizing agents, or by plasma or corona treatment.

Preferably a corona treatment of highly oriented polyethelene fibers having a molecular weight of at least 4 x 10⁵ as described in, for example, EP-A-144.997 is effected to this end.

As silane compound an alkoxy substituted silane compound, such as 3-aminopropyltriethoxysilane, 3-trimethoxysilylpropyl methacrylate, triethoxyvinylsilane, 3-glycidoxypropyltrimethoxysilane or trimethoxysilylpropylethylenediamine, is preferably used.

As titanate tetraisopropyl titanate, isopropyltri(dodecylbenzenesulphonyl) titanate, isopropyltri(laurylmyristyl) titanate, tetraisopropyldi(dioctyl phosphito) titanate, isopropyldi(dodecylbenzene sulphonyl)-4-aminobenzenesulphonyl titanate, isopropyltri(diisooctyl phosphato)titanate, isopropylisostearoyl di(4-aminobenzoyl) titanate, isopropyltri(dioctyl pyrophosphato)titanate, titanium isostearate methacrylate oxyacetate, isopropyltriisostearoyl titanate, ethylene isostearate methacrylate titanate, isopropyl isostearoyl dimethacryl titanate may, for example, be used. As chromium complex trivalent chromium complexes with carboxyl ligands may, for instance, be added.

Various solvents known per se may be used as solvent. The choice of the solvent depends on the solubility and the polarity of the compound. Preferably use is made of a polar solvent such as water, lower aliphatic ketones, alkanols or carboxylic esters, such as acetone, methanol, ethanol and ethylacetate.

The concentration of the solution to be used is preferably between 0.05 and 20 wt% of the compound, based on the total solution, in particular 0.1-5%.

The amount of compound used is preferably such that, immediately after it has been contacted with the compound, the object contains 1 - 20 x 10⁻⁴ mg, in particular 4 - 15 x 10⁻⁴ mg of compound per cm² of surface area. This amount also depends somewhat on the solubility and the polarity of the compound.

The temperature at which the surface of the polyethylene fibers is brought into contact with the solution of the compound may vary and depends on the reactivity of the compound used. Preferably, ambient temperature is applied.

The polyethylene fibers and the solution of the compound can be contacted by, for example, immersing the polyethylene fibers in, or passing it through, the solution of the compound, by applying the solution of the compound with a brush, or by spraying the polyethylene fibers with the solution of the compound.

A great advantage of the process according to the invention is that the treatment may also be effected locally, for example by partial immersion, or by only brushing or spraying the part where adhesion is required without impairing the original properties of the remaining part of the surface.

Polyethylene fibers treated according to the invention can easily be glued, painted, lacquered, coated with ink, or provided with a layer of material that is more polar than the polyolefin. These treatments are known per se. The fibers treated appeared to retain their adhesive strength for a long time. Even after storage for more than three months the adhesive strength of the fibers treated according to the invention appeared to be hardly less than immediately after treatment.

Polyethylene fibers treated according to the invention adhere well to materials with a polar character, such as resins and polyamides or rubbers. This is of particular importance in composites : materials (the so-called matrix) reinforced with fibrous materials.

When polyethylene fibers are treated according to the invention they become extremely suitable for use as reinforcing material in composites, because the adhesion between the fibers and the matrix improves considerably.

These fibers may be incorporated into polymer matrices in a manner known per se, for example by impregnation of fabrics or by winding. (A general survey of techniques commonly applied to this end is given in the 'Handbook of Composites' by Luben, G., published in 1982 by Van Nostrand Reinhold Co. (New York)).

Polyethylene fibers treated according to the invention are particularly suitable for reinforcing polar polymeric materials such as epoxy, phenolic, vinyl ester, polyester, acrylate, cyanoacrylate, polymethyl methacrylate resins and polyamide materials and rubbers. Preferably an epoxy resin, nylon or an unsaturated polyester is used as matrix.

The composites thus obtained have a very wide range of technical applications, for example in boats, surf boards, (glider) aircraft parts, printed circuit boards and car parts, such as bonnets, and mudguards.

Highly oriented polyethylene fibers are used. They can be prepared using solutions of a high-molecular polyethylene as starting material, see for instance US-A-4.344.908, US-A-4.411.854, US-A-4.422.993, US-A-4.430.383, US-A-4.436.689, US 4.668.717, GB-A-2164.897 and EP-A-181.016. In these patents a solution of a linear polyethylene with a weight average molecular weight of at least 4 x 10⁵ g/mol is spun or extruded, the fiber obtained after spinning or extrusion is converted into a gel fiber by cooling, and this gel fiber is stretched at increased temperature. It is also known to prepare such fibers using a melt of a polyethylene as starting material, see for example US 4.525.564.

Highly oriented polyethylene fibers which have been obtained by ultradrawing gel fibers spun from a solution (draw ratio more than 20) and which have an extremely high tensile strength, for example more than 2 GPa, and an extremely high modulus, for example more than 50 GPa, are used as polyethylene fibers.

As high-molecular linear polyethylene with a weight average molecular weight of at least 4 x 10⁵ g/mol, especially of at least 6 x 10⁵ g/mol, is preferably used, which may contain minor amounts, preferably at most 5 mole %, of one or more other alkenes copolymerised with it, such as propylene, butene, pentene, hexene, 4-methylpentene or octene, with the polymer chains consisting of unbranched carbon chains of at least 100 carbon atoms, preferably at least 300 carbon atoms, between carbon atoms with side chains of more than 1 C atom. Preferably a polyethylene containing 2-30, in particular 3-12, methyl or ethyl side groups per 1000 carbon atoms is used. The polyethylene may contain minor amounts, preferably at most 25 wt% based on the total polymer, of one or more other polymers, in particular an alkene-1-polymer such as polypropylene, polybutene or a copolymer of propylene with a minor amount of ethylene. In addition, an ethylenepropylene copolymer may be used as high-molecular linear polyethylene.

The invention will now be elucidated with an example.

### Example

A polyethylene fibre (Mw = 1.9 x 10⁶ g/mol) with a modulus of 109 GPa, a tensile strength of 2.4 GPa, and 800 dtex, obtained according to the process described in US 4.668.717, was subjected to a corona treatment according to the process described in EP 144.997 and subsequently drawn through a 1.0 wt% solution of 3-aminopropyltriethoxysilane in water, at room temperature.
The contact time of the fibre and the solution was about 30 seconds. Subsequently, the fibre was dried in a flow of hot air. The tensile strength and modulus of the treated fibres was about 95% of that of the untreated fibres.

An amount of treated fibre was incorporated into an epoxy resin (100 parts of Europox® 730 supplied by Schering, 83 parts of phthalic anhydride and 0.3 parts of benzyldimethylamine) in a ratio of 50 vol% fibre and 50 vol% resin. This mixture was shaped into a 150 mm long, 3 mm high and 4 mm wide test rod. The composite was cured at 80¤C for 5 hours and at 120¤C for 15 hours. The test rod was then sawn into 18 mm long test pieces.

The ILLS (interlaminar shear strength) of these test pieces was measured with a testing speed of 1 mm/min according to the ASTM 3 point bending test D 2344.
For the purpose of comparison, the ILLS was also determined of test pieces prepared according to the above-mentioned process and composed of the aforementioned epoxy resin and untreated fibre and corona-treated fibre, respectively.

The results are presented below.

| Fibre | ILLS (MPa) |
|---|---|
| Untreated | 12.5 ± 0.7 |
| Corona treated (250 W; 25 m/min) | 19.5 ± 1.0 |
| Corona treated (250 W; 25 m/min) + silane | 25.5 ± 1.5 |

## Claims

1. Process for the treatment of surfaces of highly oriented polyethylene fibers, having a weight average molecular weight of at least 400.000 g/mol, characterized in that the surface of the fiber is oxidized and contacted with a solution of a silane compound, a titanate or chromium complex.

2. Process according to claim 1, characterized in that the polyethylene fiber is obtained by converting a solution of a linear polyethylene with a weight average molecular weight of at least 400,000 g/mol into a fiber, at a temperature above the dissolution temperature, cooling this fiber to form a gel-like fiber and stretching this fiber at increased temperature, whether or not after complete or partial removal of solvent.

3. Process according to claim 1 or 2, characterized in that the surface is oxidized by corona treatment.

4. Process according to one or more of claims 1-3, characterized in that an alkoxy substituted silane compound is used as silane compound.

5. Process according to claim 4, characterized in that 3-aminopropyltriethoxy silane is used.

6. Process according to one or more of claims 1-4, characterized in that a solution is used containing 0.05-20 wt.% of compound based on the total weight of the solution.

7. Process according to one or more of claims 1-6, characterized in that a polar solvent such as water, a lower aliphatic ketone, alcohol or carboxylic ester is used as solvent.

8. Process according to one or more of claims 1-7, characterized in that the polyethylene fiber is contacted with such an amount of the compound that between 1 x 10⁻⁴ and 20 x 10⁻⁴ mg of compound is applied to the fiber per cm² of surface area.

9. Process according to one or more of claims 1-8, characterized in that a polyethylene filament is used which has been obtained by ultradrawing gel filaments spun from a solution and which has a tensile strength of more than 2 GPa and a modulus of more than 50 GPa.

10. Composite, characterized in that as reinforcing material it comprises a polyethylene fiber, obtained by applying a process according to any one of claims 1-9.

11. Composite according to claim 10, characterized in that the matrix material is an epoxy resin, nylon or unsaturated polyester.

12. Object entirely or partially manufactured from a composite according to claim 10 or 11.

## Patentansprüche

1. Verfahren zur Behandlung von Oberflächen von hochorientierten Polyäthylenfasern mit einem gewichtsmittleren Molgewicht von mindestens 400 000 g/Mol, dadurch gekennzeichnet, daß die Oberfläche der Faser oxidiert und mit einer Lösung einer Silanverbindung, eines Titanats oder eines Chromkomplexes in Berührung gebracht wird.

2. Verfahren nach Anspruch 1, dadurch gekennzeichnet, daß die Polyäthylenfaser durch Überführen einer Lösung eines linearen Polyäthylens mit einem gewichtsmittleren Molgewicht von mindestens 400 000 g/Mol bei einer Temperatur oberhalb der Lösungstemperatur in eine Faser, Abkühlen dieser Faser unter Bildung einer gelartigen Faser und Strecken dieser Faser bei erhöhter Temperatur, gegebenenfalls nach völliger oder teilweiser Entfernung des Lösungsmittels, erhalten wird.

3. Verfahren nach Anspruch 1 oder 2, dadurch gekennzeichnet, daß die Oberfläche durch Koronabehandlung oxidiert wird.

4. Verfahren nach einem oder mehreren der Ansprüche 1 bis 3, dadurch gekennzeichnet, daß eine alkoxysubstituierte Silanverbindung als Silanverbindung verwendet wird.

5. Verfahren nach Anspruch 4, dadurch gekennzeichnet, daß 3-Aminopropyltriäthoxysilan verwendet wird.

6. Verfahren nach einem oder mehreren der Ansprüche 1 bis 4, dadurch gekennzeichnet, daß eine Lösung verwendet wird, die 0,05 bis 20 Gew.% Verbindung, bezogen auf das Gesamtgewicht der Lösung, enthält.

7. Verfahren nach einem oder mehreren der Ansprüche 1 bis 6, dadurch gekennzeichnet, daß ein polares Lösungsmittel, wie Wasser, ein niedriges aliphatisches Keton, ein Alkohol oder Carbonsäureester als Lösungsmittel verwendet wird.

8. Verfahren nach einem oder mehreren der Ansprüche 1 bis 7, dadurch gekennzeichnet, daß die Polyäthylenfaser mit einer solchen Menge der Verbindung in Berührung gebracht wird, daß 1 x 10⁻⁴ bis 20 x 10⁻⁴ mg Verbindung auf die Faser pro cm² Oberfläche aufgebracht wird.

9. Verfahren nach einem oder mehreren der Ansprüche 1 bis 8, dadurch gekennzeichnet, daß ein Polyäthylenfaden verwendet wird, der durch Ultraziehen von aus einer Lösung gesponnenen Gelfäden erhalten wurde und eine Zugfestigkeit von mehr als 2 GPa und einen Modul von mehr als 50 GPa aufweist.

10. Verbundstoff, dadurch gekennzeichnet, daß er als Verstärkungsmaterial eine Polyäthylenfaser aufweist, die durch Anwenden des Verfahrens nach einem der Ansprüche 1 bis 9 erhalten wurde.

11. Verbundstoff nach Anspruch 10, dadurch gekennzeichnet, daß das Matrixmaterial ein Epoxyharz, Nylon oder ungesättigter Polyester ist.

12. Gegenstand, der vollständig oder teilweise aus einem Verbundstoff nach Anspruch 10 oder 11 hergestellt ist.

## Revendications

1. Procédé pour le traitement de surfaces de fibres de polyéthylène hautement orientées, ayant un poids moléculaire moyen en poids d'au moins 400 000 g/mol, caractérisé en ce que la surface de la libre est oxydée et mise en contact avec une solution d'un composé silane, un titanate ou un complexe de chrome.

2. Procédé selon la revendication 1, caractérisé en ce que la fibre de polyéthylène est obtenue en transformant une solution d'un polyéthylène linéaire d'au moins un poids moléculaire moyen en poids de 400 000 g/mol en une fibre, à une température supérieure à la température de dissolution, en refroidissant cette libre pour former une libre semblable à un gel et en étirant cette fibre à une température plus élevée, que cela soit ou non après extraction complète ou partielle du solvant.

3. Procédé selon la revendication 1 ou 2, caractérisé en ce que la surface est oxydée par traitement par décharge corona.

4. Procédé selon une ou plusieurs des revendications 1 à 3, caractérisé en ce que l'on utilise un composé silane alkoxy substitué comme composé silane.

5. Procédé selon la revendication 4, caractérisé en ce qu'on utilise du 3-aminopropyltriéthoxy silane.

6. Procédé selon une ou plusieurs des revendications 1 à 4, caractérisé en ce qu'on utilise une solution contenant de 0,05 à 20% en poids du composé, calculé sur le poids total de la solution.

7. Procédé selon une ou plusieurs des revendications 1 à 6, caractérisé en ce que l'on utilise comme solvant, un solvant polaire tel que l'eau, une cétone aliphatique inférieure, un alcool ou un ester carboxylique.

8. Procédé selon une ou plusieurs des revendications 1 à 7, caractérisé en ce que la fibre de polyéthylène est mise en contact avec une quantité du composé telle que de 1 x 10⁻⁴ à 20 x 10⁻⁴ mg du composé soient appliqués à la libre par centimètre carré de surface.

9. Procédé selon une ou plusieurs des revendications 1 à 8, caractérisé en ce qu'on utilise un filament de polyéthylène qui a été obtenu par ultraétirage de filaments gélifiés filés à partir d'une solution et qui ont une résistance à la rupture par traction de plus de 2 GPa et un module d'élasticité de plus de 50 GPa.

10. Composite, caractérisé en ce qu'il comprend, en tant que matériau de renforcement, une libre de polyéthylène obtenue en mettant en oeuvre un procédé conforme à l'une quelconque des revendications 1 à 9.

11. Composite conforme à la revendication 10, caractérisé en ce que le matériau de la matrice est une résine époxy, un nylon ou un polyester insaturé.

12. Objet fabriqué entièrement ou en partie à partir d'un composite conforme à la revendication 10 ou 11.
